# EUROPÄISCHE PATENTSCHRIFT

(11) **EP 1 560 253 B1**
(45) Veröffentlichungstag und Bekanntmachung des Hinweises auf die Patenterteilung: **17.10.2007**
(21) Anmeldenummer: 05000927.3
(22) Anmeldetag: 18.01.2005
(51) Int. Cl.: C23C 14/00, C23C 14/56, H01J 37/32

(54) **Vorrichtung zum Beschichten eines Substrats mit einer Absorberanordnung**
Apparatus for coating a substrate, the apparatus comprising a gettering device
Appareil destiné au revêtement de substrats, l'appareil comprenant un sorbeur

(30) Priorität: 30.01.2004 DE 102004004844
(43) Veröffentlichungstag der Anmeldung: 03.08.2005
(73) Patentinhaber: INTERPANE Entwicklungs- und Beratungsgesellschaft mbH & Co. KG, D-37697 Lauenförde (DE)
(72) Erfinder: Böwer, Reimund, 37688 Beverungen (DE); Mönnekes, Jörg, 37671 Höxter (DE); Herlitze, Lothar, Dr., 37691 Derental (DE)
(74) Vertreter: Körfer, Thomas

(56) Entgegenhaltungen:
- DD-A1- 214 865
- US-A1- 2001 015 173

## Beschreibung

Die Erfindung bezieht sich auf eine Vorrichtung zum Beschichten eines Substrats mit einer Absorberanordnung nach dem Oberbegriff des Anspruchs 1.

Beispielsweise ist aus der EP 0 783 174 A2 eine Vorrichtung gemäß dem Oberbegriff des Anspruchs 1 bekannt. Bei der dort beschriebenen Vorrichtung zum Beschichten eines Substrats mit einer Wechselstromquelle, die mit zwei Kathoden verbunden ist, ist der eine Pol der Wechselstromquelle an die eine Kathode und der andere Pol an die andere Kathode über Versorgungsleitungen angeschlossen, wobei jede der beiden Kathoden in einem eigenen Abteil einer Vielzahl von benachbart angeordneten, zusammen eine Vakuumkammer bildenden, über einen Durchgang miteinander verbundenen Abteilen vorgesehen ist.

Aus der EP 0 983 973 A2 ist ein Verfahren für die Erzeugung einer niedrigemittierenden Schicht auf einem Glassubstrat bekannt, bei welchem zunächst eine reflektierende Metallschicht und dann eine Metalloxidschicht unter Anwesenheit eines Sauerstoffabsorbers auf das Substrat aufgebracht wird. Als Sauerstoffabsorber wird vorzugsweise ein Kohlenwasserstoff wie Methan verwendet. Die Metalloxidschicht kann dabei beispielsweise aus Zinnoxid, Zinkoxid, Wolframoxid oder anderen Metalloxiden bestehen.

Nachteilig an den aus den oben genannten Druckschriften bekannten Vorrichtungen und Verfahren ist insbesondere, daß die Herstellung der Metallschichten entweder die Anwesenheit eines gasförmigen Sauerstoffabsorbers erfordert oder die Aufbringung der Metall- und der Metalloxidschichten räumlich relativ weit voneinander getrennt stattfinden muß. Eine entsprechende Anlage ist somit von großer Baulänge und folglich kostenintensiv in Bereitstellung und Betrieb.

Die DD 214 865 A1 offenbart ein Verfahren und eine Einrichtung zur Herstellung von Schichtsystemen auf Flachglas durch Plasmatronzerstäuben. Dabei sollen im Durchlaufverfahren Metall- und Metalloxidschichten in wechselnder Folge aufgebracht werden. Argon wird in die metallische Beschichtungskammer eingelassen und nach Durchströmen der oxidischen Kammer aus dieser abgesaugt. Der Argondruck in der metallischen Kammer liegt über dem Partialdruck in der oxidischen Kammer. Das Reaktionsgas wird zwischen den Kammern selektiv abgesaugt.

Die US 2001//015173 A1 offenbart eine Vorrichtung zum Herstellen dünner Schichten auf einem Metallsubstrat. Unabhängige Targets, welche aus zumindest zwei Metallen gebildet sind, werden durch Sputtern aufgebracht, um einen ultra-dünnen Film eines Verbundmetalls zu bilden. Der ultradünne Film wird mit einem reaktiven Gas behandelt. Die Schritte werden mehrmals wiederholt, bis ein Film gewünschter Dicke entstanden ist.

Der Erfindung liegt daher die Aufgabe zu Grunde, eine Vorrichtung zum Beschichten eines Substrats zu schaffen, bei welcher die Beschichtung des Substrats mit Metall und mit Metalloxiden in der gleichen Vorrichtung in räumlicher Nähe zueinander stattfinden kann.

Die Aufgabe wird durch die Merkmale des Anspruchs 1 gelöst.

Bei der erfindungsgemäß ausgestalteten Vorrichtung ist dabei in zumindest einem der Fächer eine Absorberanordnung vorhanden, welche den freien Sauerstoff oder ein beliebiges anderes Reaktivgas wie z.B. Stickstoff aufnimmt, so daß das Substrat, welches unter der Absorberanordnung durchgeführt wird, in folgenden oder in davor liegenden Fächern z. B. mit einer Metallschicht versehen werden kann, deren Qualität nicht durch Sauerstoff, Stickstoff oder ein anderes Reaktivgas herabgesetzt wird. Die Absorberanordnung weist dabei eine Kathodenanordnung auf, welche als Getterkathode fungiert, indem sie fortwährend in der Absorberanordnung eine Metallschicht erzeugt, die zur Reaktion mit dem Reaktivgas zur Verfügung steht.

Die Absorberanordnung umfaßt zur Vergrößerung der Oberfläche mehrere plattenförmige Metallelemente.

Außerdem ist zur Vergrößerung der reaktiven Oberfläche ein Sieb zwischen den plattenförmigen Metallelementen und dem Substrat eingesetzt.

Vorteilhafte Weiterbildungen der Erfindung sind in den Unteransprüchen beschrieben.

Vorteilhafterweise ist die Vorrichtung gekühlt, indem die plattenförmigen Metallelemente beispielsweise von einer Kühlflüssigkeit durchströmt werden.

Nachfolgend werden vorteilhafte Ausgestaltungsformen der Erfindung anhand bevorzugter Ausführungsbeispiele unter Bezugnahme auf die Zeichnung näher erläutert. Es zeigen:
- Fig. 1: eine schematische, geschnittene seitliche Darstellung eines Ausführungsbeispiels einer Vorrichtung zur Beschichtung eines Substrates gemäß dem Stand der Technik,
- Fig. 2A: eine prinzipielle Darstellung eines Fachs einer erfindungsgemäß ausgestalteten Vorrichtung zur Beschichtung eines Substrates mit einer Absorberanordnung gemäß einem ersten Ausführungsbeispiel,
- Fig. 2B: eine prinzipielle Darstellung einer Vorrichtung zur Beschichtung eines Substrates mit einer Absorberanordnung,
- Fig. 3A: eine Darstellung dreier benachbarter Fächer der Vorrichtung gemäß Fig. 2A mit den Vakuumpumpen,
- Fig. 3B: eine Darstellung dreier benachbarter Fächer der Vorrichtung gemäß Fig. 3A mit eingeschalteter Kathode,
- Fig. 4: eine schematische Darstellung mehrerer Fächer einer erfindungsgemäß ausgestalteten Vorrichtung mit der Kathodenanordnung, und
- Fig. 5A-B: Diagramme des Sauerstoffpartialdrucks in einem ausgewählten Fach einer erfindungsgemäß ausgestalteten Vorrichtung.

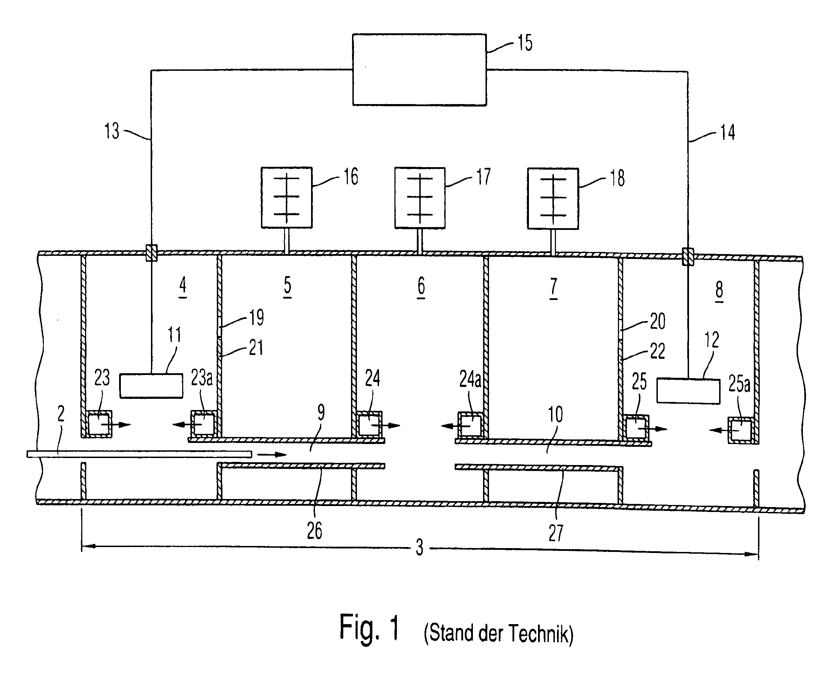

Fig. 1 zeigt zur besseren Verständlichkeit der erfindungsgemäßen Maßnahmen zunächst in einer schematischen Schnittansicht ein Ausführungsbeispiel einer Vorrichtung 1 zur Beschichtung eines Substrates 2 gemäß dem Stand der Technik in einer seitlichen Gesamtansicht.

Eine derartige Vorrichtung 1 dient zum Beschichten eines Substrats 2 wie z.B. Glas mit verschiedenen Beschichtungen wie z.B. Wärmeschutzschichten oder Sonnenschutzschichten.

Die Vorrichtung 1 umfaßt dabei eine Vakuum-Hauptkammer 3, die in eine Vielzahl von Fächern 4 bis 8 aufgeteilt ist, wobei alle Fächer 4 bis 8 über einen mit Hilfe von Schächten 26, 27 gebildeten Durchgang 9, 10 untereinander in Verbindung stehen und einzelne Fächer 4 und 8 jeweils mit einer Sputter-Kathode 11, 12 ausgestattet sind, wobei die beiden Kathoden 11, 12 über Versorgungsleitungen 13, 14 z.B. mit einer Wechselstromquelle 15, beispielsweise einem Mittelfrequenzgenerator, verbunden sind. Das zweite, dritte und vierte Fach 5, 6, 7 ist im Ausführungsbeispiel jeweils an eine eigene Vakuumpumpe 16, 17, 18, z.B. eine Turbopumpe, angeschlossen, wobei die beiden Fächer 4, 5 und 7, 8 untereinander über Öffnungen 19, 20 in den jeweiligen Trennwänden 21, 22 verbunden sind. Die Fächer 4, 6 und 8 sind im dargestellten Ausführungsbeispiel an Gaszufuhrleitungen 23, 23a, 24, 24a, 25 und 25a angeschlossen, über welche Prozeßgas bzw. über die Gaszufuhrleitungen 24 und 24a Reaktivgas in die einzelnen Fächer 4 bis 8 eingelassen werden kann. Alternativ kann das Reaktivgas auch in den Kathodenfächern zugeführt werden. Das Substrat 2 wird während des Beschichtungsvorgangs entlang dem Durchgang 9, 10 bzw. durch die Schächte 26, 27 transportiert und an den Kathoden 11, 12 vorbeibewegt.

Ein Problem der beschriebenen Vakuumkammer 3 ist die Verbindung der einzelnen Fächer 4 bis 8 untereinander. Die Verbindung ist nicht zu umgehen, da das zu beschichtende Substrat 2 an allen Fächern 4 bis 8 vorbeigeführt werden muß, um die gewünschte Beschichtung aufbringen zu können. Sollen jedoch mehrere Schichten auf das Substrat 2 aufgebracht werden, insbesondere beispielsweise abwechselnde Schichten aus Metallen und Metalloxiden, besteht ein Problem, da die Reaktivgasatmosphäre, in diesem Fall die Sauerstoffatmosphäre, welche für die Beschichtung mit einem Metalloxid in das entsprechende Fach 4 bis 8 eingeleitet wird, mit vermindertem Partialdruck auch in diejenigen Fächer eindringen kann, in welchen eine Beschichtung mit dem Metall erfolgen soll. Dringt jedoch Sauerstoff ein, besteht die Gefahr, daß die Metallbeschichtung unerwünschterweise teilweise oxidiert und sich deren Eigenschaften verändern. Ähnliches gilt für Nitrierung mit Stickstoff bzw. Verbindungen mit anderen Reaktivgasen. Zur Vermeidung des Überströmens von Reaktivgas hat man sich bisher einer räumlich möglichst weiten Trennung der Fächer für die Metallbeschichtung von denjenigen für die sonstigen Beschichtung bedient, wodurch die Vorrichtung 1 eine sehr große Baulänge erhält und daher kosten- und platzintensiv ist.

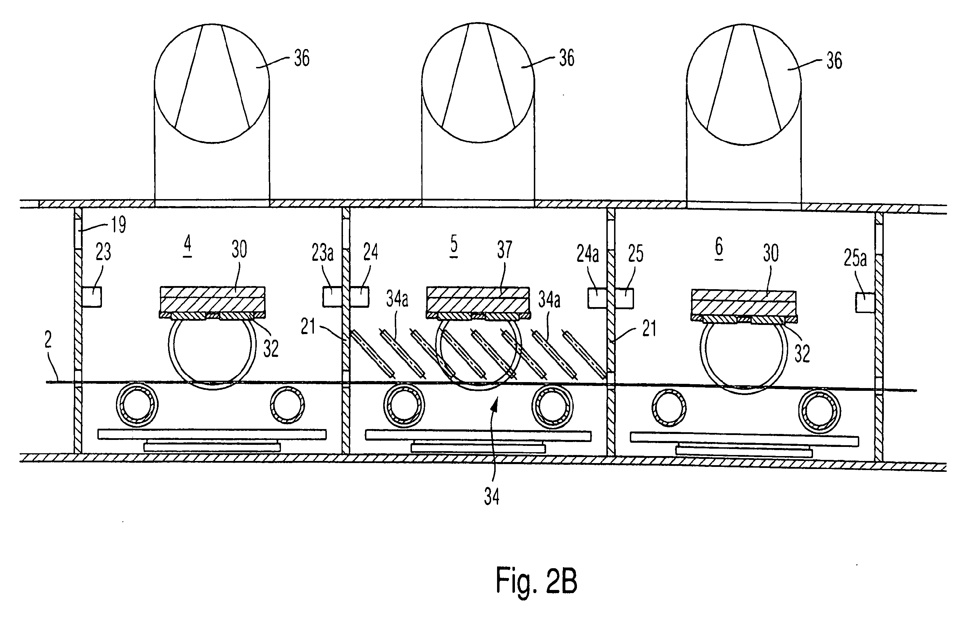

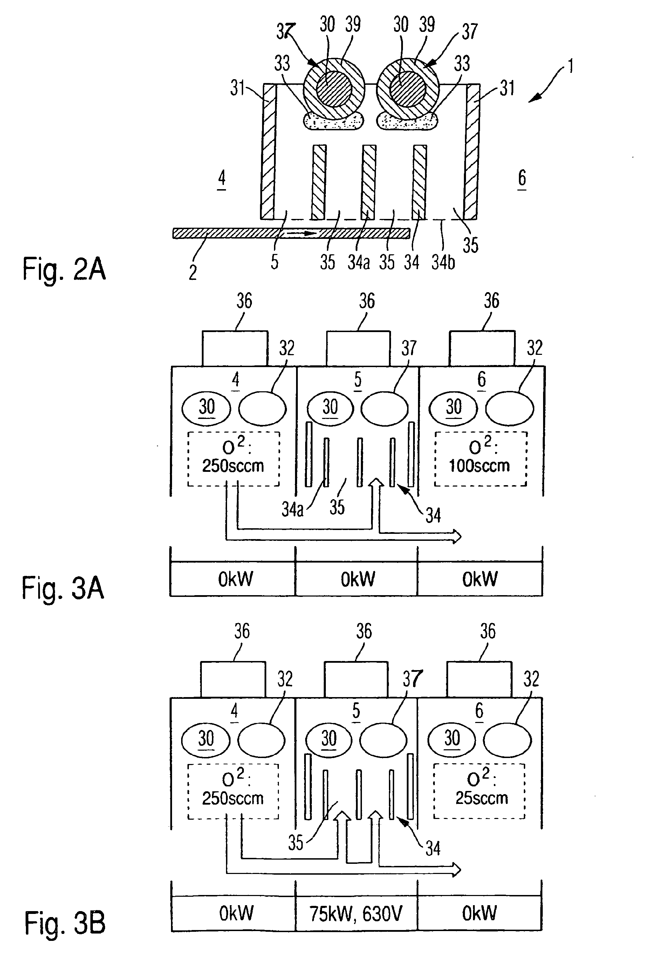

Eine Vorrichtung 1 gemäß den Fig. 2 bis 4 weist demgegenüber eine Absorberanordnung 34 zur aktiven Abscheidung des Reaktivgases durch Gettern mit einer Kathodenanordnung 37 auf, wodurch es möglich ist, in eng benachbarten Fächern der Vorrichtung 1 verschiedene Beschichtungen durchzuführen, welche unterschiedliche Reaktivgasbedürfnisse haben. Dadurch können in räumlich eng benachbarten Fächern reaktive und nichtreaktive Atmosphären erzeugt werden. Die Vorrichtung 1 kann damit eine erheblich verkürzte Baulänge aufweisen, was sich positiv auf die Kosten sowohl der Bereitstellung als auch des Betriebs auswirkt.

Fig. 2A zeigt in einer stark schematisierten Darstellung den prinzipiellen Aufbau einer erfindungsgemäß ausgestalteten Vorrichtung 1. Dabei ist zumindest ein Fach 5 mit einer als Doppelkathode 30 ausgebildeten Kathodenanordnung 37 versehen. Das Fach 5 ist durch Wandungen 31 von angrenzenden Fächern 4 und 6 getrennt. Die Wandungen 31 können dabei aus weiter unten näher erläuterten Gründen gekühlt sein.

Die Doppelkathode 30 weist im Ausführungsbeispiel zwei Targets 39 auf, welche beispielsweise aus Aluminium Al oder Titan Ti bestehen. Andere geeignete Targetmaterialien sind z.B. die Elemente Ta, Th und Zr. Unterhalb der Targets 39 bilden sich während des Betriebs der Kathodenanordnung 37 Plasmawolken 33 aus. Zwischen den Wandungen 31 des Fachs 5 sind im Ausführungsbeispiel senkrecht zum Substrat 2 bzw. parallel zu den Wandungen 31 plattenförmige Elemente 34a, beispielsweise aus Metallblechen, angeordnet, welche das Fach 5 in einzelne Bereiche 35 aufteilen und die Absorberanordnung 34 bilden.

Die optimale Form und Anordnung der plattenförmigen Elemente 34a ist dabei durch die Überlegung bestimmt, daß möglichst wenige Teilchen des reaktiven Gases an der Absorberanordnung 34 vorbeidiffundieren können.

So sind beispielsweise, wie in Fig. 2B dargestellt, plattenförmige Elemente 34a in geneigter Position sinnvoll, da dadurch die zur Verfügung stehende effektive Fläche zum Gettern größer ist als bei erfindungsgemäß senkrecht stehenden plattenförmigen Elementen 34a.

Möglich ist auch eine Anordnung in labyrinthischer Anordnung, versetzt zueinander angeordnete Elemente 34a oder auch kammartig ineinandergreifende, mit Löchern oder Schlitzen versehene Elemente 34a denkbar. Je mehr plattenförmige Elemente 34a verwendet werden, desto höher ist die Getterwirkung.

Die Targetmaterialien müssen dabei so gewählt werden, daß einerseits eine sehr gute Getterwirkung erzielt wird und andererseits verwandte optische Eigenschaften zur vorhergehenden Beschichtung vorhanden sind, damit es nicht zu materialtechnischem Unverträglichkeiten kommt. So sollte beispielsweise Al über einer ZnAl-Oxidschicht oder Ti über einer Titanschicht für den Aufbau eines Titanoxidgradienten verwendet werden. Unverträglichkeiten der Materialien können sich beispielsweise in optischer Absorption, Schichthaftungsproblemen oder Teilchendiffusion ausdrücken.

Wird nun beispielsweise in Fach 4 in einer oxidischen Atmosphäre und in Fach 6 in einer nichtoxidischen, z.B. nitridischen Atmosphäre gesputtert, besteht bei herkömmlichen Vorrichtungen 1 die Gefahr des Übertrags von Sauerstoff in die nitridische Atmosphäre mit der Folge der Verunreinigung der Metallnitridschicht. Dem wird durch die erfindungsgemäße Weiterbildung dadurch entgegengewirkt, daß sich die von dem Fach 4 zum Fach 6 diffundierenden Sauerstoffatome im dazwischenliegenden Fach 5 an den Elementen 34a der Absorberanordnung 34, die stets mit einer Metallschicht mit hoher Affinität zu Sauerstoff durch die Kathodenanordnung 37 überzogen wird, zu Metalloxiden reagieren und so absorbiert werden.

Fig. 3A und 3B zeigen stark schematisiert die Wirkungsweise der Absorberanordnung 34 mit der Kathodenanordnung 37 gemäß Fig. 2A. In Fig. 3A ist zunächst die Situation bei ausgeschalteter Doppelkathode 30 dargestellt, während Fig. 3B die Wirkungsweise mit zugeschalteter Doppelkathode 30 zeigt.

Dabei sind drei aneinandergrenzende Fächer 4, 5 und 6 einer Vorrichtung 1 zum Beschichten eines Substrats 2 dargestellt, von denen das mittlere Fach 5 die oben erwähnten Absorberanordnung 34 und Kathodenanordnung 37 aufweist. Die Vorrichtung 1 weist dabei im dargestellten Ausführungsbeispiel pro Fach 4, 5, 6 je mindestens eine Turbopumpe 36 auf, welche für die Erzeugung des Vakuums benötigt werden. In Fach 4 herrscht ein bestimmter Sauerstoffpartialdruck, welcher einem Reaktivgasfluß von beispielsweise ca. 250 sccm entspricht, zum Aufsputtern einer Metalloxidschicht auf das Substrat 2. Ohne weitere Maßnahmen diffundiert der Sauerstoff in die angrenzenden Fächer, so daß in Fach 6, wo eine Metallschicht aufgesputtert werden soll, immer noch ein Sauerstoffpartialdruck entsprechend einem Reaktivgasfluß von ca. 100 sccm herrscht, was die Qualität der Metallbeschichtung stark beeinträchtigen würde.

Werden jedoch, wie in Fig. 3B dargestellt, eine Kathodenanordnung 37 und eine Absorberanordnung 34 in Fach 5 eingesetzt, welche bei einer definierten Leistung und Spannung, im Ausführungsbeispiel 75 kW bei 630 V, betrieben werden, kann die Sauerstoffkonzentration in Fach 6 auf einen Reaktivgasfluß von ca. 25 sccm gesenkt werden, was im Vergleich zum Reaktivgasfluß in Fach 4 lediglich ein Zehntel beträgt. Ohne eingeschaltete Doppelkathode 30 liegt noch der vierfache Reaktivgasfluß in Fach 6 vor.

Hierbei reagiert der aus dem Fach 4 überströmende Sauerstoff mit der Metallschicht auf den plattenförmigen Elementen 34a der Absorberanordnung 34 und schlägt sich als Metalloxid an den Elementen 34a in Fach 5 nieder. In der Folge sinkt der Reaktivgasfluß in Fach 5, so daß weniger Sauerstoff in das nächste Fach 6 überströmen kann. Entsprechendes kann auch für Stickstoff sowie andere Reaktivgase mit den entsprechenden Targetmaterialien realisiert werden.

Die plattenförmigen Elemente 34a sind dabei vorzugsweise wie auch die Wandungen 31 gekühlt, indem die plattenförmigen Elemente 34a beispielsweise doppelwandig ausgebildet sind und von einem Kühlmittel durchströmt werden. Dies erhöht und stabilisiert die Reaktivität der Oberflächen.

Damit eine möglichst große Fläche zum Abfangen des Sauerstoffs zur Verfügung steht, werden die Elemente 34a vor der Montage vorzugsweise sandgestrahlt, damit sie eine hohe Rauhigkeit aufweisen. Zur weiteren Vergrößerung der reaktiven Oberfläche ist erfindungsgemäß unterhalb der plattenförmigen Elemente 34a ein in Fig. 2A dargestelltes Sieb 34b, z.B. aus einem Metalldrahtgeflecht, angeordnet. Die Platten können, wie weiter oben bereits erwähnt, geneigt oder labyrinthisch angeordnet und mit Löchern oder Schlitzen versehen sein. Je mehr plattenförmige Elemente 34a vorhanden sind, desto größer ist die zum Absorbieren zu Verfügung stehende Oberfläche und desto besser folglich die aktive Gastrennung.

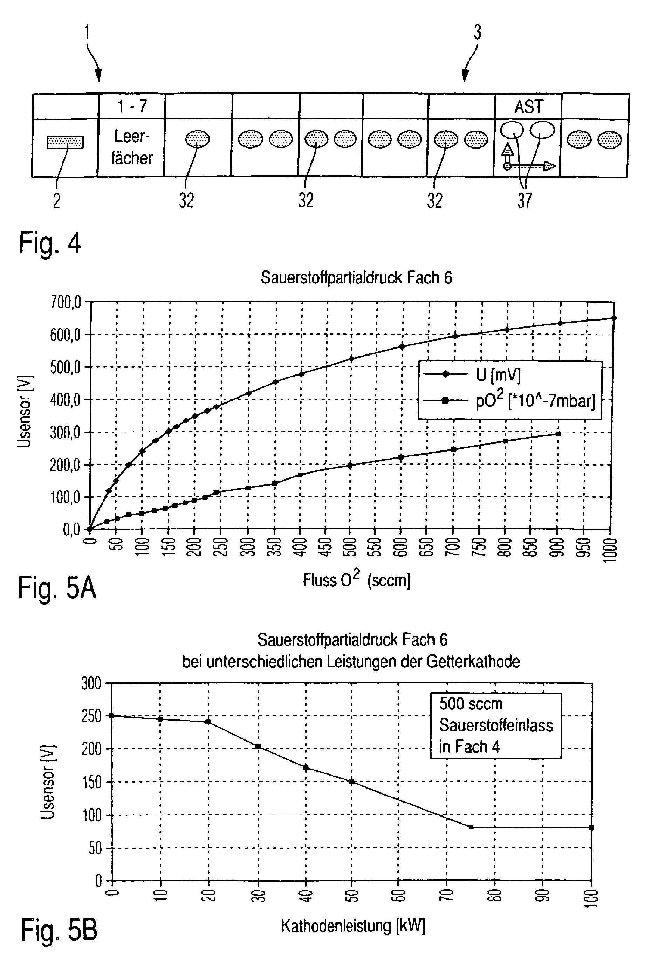

In Fig. 4 ist stark schematisiert eine Gesamtübersicht über eine erfindungsgemäß ausgestaltete Vorrichtung 1 dargestellt. Das Substrat 2 durchläuft zunächst eine Anzahl von leeren Fächern und wird dann mittels entsprechender Targets 32 in mehreren aufeinanderfolgenden Fächern beispielsweise mit einer Metalloxid- oder -nitridschicht versehen. Danach erfolgt in dem mit AST bezeichneten Fach die aktive Gastrennung mittels der nicht weiter dargestellten Absorberanordnung 34 und der Kathodenanordnung 37. Im nächsten Fach kann dann sofort mit dem Aufsputtern beispielsweise einer Metallschicht begonnen werden, ohne daß eine nennenswerte Verunreinigung mit Reaktivgas auftritt.

Dadurch ist es möglich, bei einer relativ kurzen Anlagenlänge der Vorrichtung 1 nicht nur eine, sondern mehrere Schichten von Metallen, Metalloxiden, Metallnitriden oder anderen Schichten, welche verschiedene Reaktivgasatmosphären benötigen, auf das Substrat 2 aufzubringen. So können beispielsweise in eng benachbarten Fächern Metall-, Metalloxid- und Metallnitridschichten aufgebracht werden, z.B. Zinkoxid ZnOx neben Aluminiumnitrid AlN.

Fig. 5A und 5B zeigen zur Verdeutlichung der Erfindung zwei Diagramme, welche den Sauerstoffpartialdruck in Fach 6 darstellen. In Fig. 5A sind dabei das Signal des Sauerstoffsensors in Fach 6 sowie der Sauerstoffpartialdruck in Abhängigkeit von der Menge des in Fach 4 eingeleiteten Gases dargestellt, während Fig. 5B den Sauerstoffhaushalt in Fach 6 bei konstantem Gaseinlaß in Fach 4 und variierter Leistung der Kathodenanordnung 37 in Fach 5 zeigt. Deutlich erkennbar ist dabei die ansteigende Absorptions- oder Getterwirkung der Kathodenanordnung 37, was sich durch einen sinkenden Sauerstoffpartialdruck in Fach 6 zeigt. Bei einer Leistung von etwa 75 kW wird ein Sättigungswert erreicht, jenseits dessen eine weitere Leistungssteigerung keine nennenswerte Verringerung des Sauerstoffpartialdrucks in Fach 6 mehr bewirkt.

Die Erfindung ist nicht auf das dargestellte Ausführungsbeispiel beschränkt. Insbesondere sind auch andere räumliche Konfigurationen möglich.

Sämtliche Merkmale sind beliebig miteinander kombinierbar.

## Patentansprüche

1. Vorrichtung (1) zum Beschichten eines Substrats (2), umfassend eine Vakuumkammer (3), welche durch Wandungen (31) in mehrere Fächer (4 - 8) aufgeteilt ist,
wobei zumindest eine Kathoden-Targetanordnung (32) in zumindest einem der Fächer (4 - 8) angeordnet ist,
wobei zumindest ein Fach (5) eine Absorberanordnung (34) und zumindest eine Kathodenanordnung (37) zum Gettern aufweist,
wobei das zumindest eine an das mit der Kathodenanordnung (37) und der Absorberanordnung (34) versehene Fach (5) angrenzende Fach (4) Gaszufuhrleitungen (23, 23a) zur Herstellung einer oxidischen oder nitridischen Atmosphäre aufweist, **dadurch gekennzeichnet daß**
die Absorberanordnung (34) eine Vielzahl von plattenförmigen Elementen (34a) aufweist, welche zwischen den Wandungen (31) des Fachs (5) angeordnet sind und das Fach (5) in einzelne Bereiche (35) aufteilen, und welche parallel zu den Wandungen (31) des Fachs (5) und senkrecht zu dem Substrat (2) angeordnet sind, und **daß**
zwischen den plattenförmigen Elementen (34a) und dem Substrat (2) ein Sieb (34b) angeordnet ist.

2. Vorrichtung nach Anspruch 1,
**dadurch gekennzeichnet,**
**dass** die Absorberanordnung (34) aus Metall besteht.

3. Vorrichtung nach Anspruch 1 oder 2,
**dadurch gekennzeichnet,**
**dass** die Absorberanordnung (34) sandgestrahlt ist.

4. Vorrichtung nach einem der Ansprüche 1 bis 3,
**dadurch gekennzeichnet,**
**dass** die Absorberanordnung (34) so angepasst ist, daß sie von einem Kühlmittel durchströmt werden kann.

5. Vorrichtung nach einem der Ansprüche 1 bis 4,
**dadurch gekennzeichnet,**
**dass** die Anzahl der plattenförmigen Elemente (34a) variabel ist.

6. Vorrichtung nach einem der Ansprüche 1 bis 5,
**dadurch gekennzeichnet,**
**dass** die Kathodenanordnung (37) als Doppelkathode (30) ausgebildet ist.

7. Vorrichtung nach einem der Ansprüche 1 bis 6,
**dadurch gekennzeichnet,**
**dass** die Kathodenanordnung (37) so angepasst ist, daß sie mit einer Spannung im Bereich von 550 V bis 700 V und/oder einer Leistung im Bereich von 50 kW bis 100 kW betreibbar ist.

8. Vorrichtung nach einem der Ansprüche 1 bis 7,
**dadurch gekennzeichnet,**
**dass** die Kathodenanordnung (37) zumindest ein Target (39) hat, dessen Material die chemischen Elemente A1 und/oder Ti und/oder Zr und/oder Ta und/oder Th beinhaltet.

9. Vorrichtung nach einem der Ansprüche 1 bis 8,
**dadurch gekennzeichnet,**
**dass** das zumindest eine an das mit der Getterkathode (37) versehene Fach (5) angrenzende Fach (6) Gaszufuhrleitungen (25, 25a) zur Herstellung einer SchutzgasAtmosphäre aufweist.

## Claims

1. Device (1) for coating a substrate (2), comprising a vacuum chamber (3) divided by walls (31) into several compartments (4 - 8),
at least one cathode target array (32) being arranged in at least one of the compartments (4 - 8),
at least one compartment (5) having an absorber array (34) and at least one cathode array (37) for gettering,
the at least one compartment (4) adjacent to the compartment (5) provided with the cathode array (37) and the absorber array (34) having gas supply lines (23, 23a) for producing an oxidic or nitridic atmosphere,
**characterized in that**
the absorber array (34) has a large number of plate-like elements (34a) which are arranged between the walls (31) of the compartment (5) and divide the compartment (5) into individual regions (35), and which are arranged parallel to the walls (31) of the compartment (5) and perpendicular to the substrate (2),
and **in that** a mesh (34b) is arranged between the plate-like elements (34a) and the substrate (2).

2. Device according to Claim 1,
**characterized in that**
the absorber array (34) is made of metal.

3. Device according to Claim 1 or 2,
**characterized in that**
the absorber array (34) is sand-blasted.

4. Device according to one of Claims 1 to 3,
**characterized in that**
the absorber array (34) is adapted so that a coolant can flow through it.

5. Device according to one of Claims 1 to 4,
**characterized in that**
the number of plate-like elements (34a) is variable.

6. Device according to one of Claims 1 to 5,
**characterized in that**
the cathode array (37) is designed as a double cathode (30).

7. Device according to one of Claims 1 to 6,
**characterized in that**
the cathode array (37) is adapted so that it can be operated at a voltage ranging from 550 V to 700 V and/or a power ranging from 50 kW to 100 kW.

8. Device according to one of Claims 1 to 7,
**characterized in that**
the cathode array (37) has at least one target (39) whose material contains the chemical elements Al and/or Ti and/or Zr and/or Ta and/or Th.

9. Device according to one of Claims 1 to 8,
**characterized in that**
the at least one compartment (6) adjacent to the compartment (5) provided with the getter cathode (37) has gas supply lines (25, 25a) for producing an inert gas atmosphere.

## Revendications

1. Dispositif (1) pour le revêtement d'un substrat (2), comprenant une chambre à vide (3), laquelle est divisée par des parois (31) en plusieurs compartiments (4 - 8),
dans lequel au moins un ensemble de cathodes (32) est disposé dans au moins un des compartiments (4 - 8),
dans lequel au moins un compartiment (5) présente un ensemble absorbeur (34) et au moins un ensemble de cathodes (37) pour le dégazage,
dans lequel au moins un compartiment (4) voisin du compartiment (5) pourvu de l'ensemble de cathodes (37) et de l'ensemble absorbeur (34) présente des conduites d'amenée de gaz (23, 23a) servant à la production d'une atmosphère oxydante ou nitrurante, **caractérisé en ce que** l'ensemble absorbeur (34) présente une pluralité d'éléments en forme de plaques (34a), qui sont disposés entre les parois (31) du compartiment (5) et partagent le compartiment (5) en zones individuelles (35), et qui sont disposés parallèlement aux parois (31) du compartiment (5) et perpendiculairement au substrat (2) et **en ce qu'**un tamis (34b) est disposé entre les éléments en forme de plaques (34a) et le substrat (2).

2. Dispositif selon la revendication 1, **caractérisé en ce que** l'ensemble absorbeur (34) est en métal.

3. Dispositif selon la revendication 1 ou 2, **caractérisé en ce que** l'ensemble absorbeur (34) est sablé.

4. Dispositif selon l'une quelconque des revendications 1 à 3, **caractérisé en ce que** l'ensemble absorbeur (34) est réalisé de sorte à pouvoir être traversé par un produit réfrigérant.

5. Dispositif selon l'une quelconque des revendications 1 à 4, **caractérisé en ce que** le nombre d'éléments en forme de plaques (34a) est variable.

6. Dispositif selon l'une quelconque des revendications 1 à 5, **caractérisé en ce que** l'ensemble de cathodes (37) est réalisé sous forme de double cathode (30).

7. Dispositif selon l'une quelconque des revendications 1 à 6, **caractérisé en ce que** l'ensemble de cathodes (37) est réalisé de sorte à pouvoir être exploité avec une tension située dans la plage allant de 550 V à 700 V et/ou une puissance située dans la plage allant de 50 kW à 100 kW.

8. Dispositif selon l'une quelconque des revendications 1 à 7, **caractérisé en ce que** l'ensemble de cathodes (37) comporte au moins une cible (39), dont le matériau contient les éléments chimiques A1 et/ou Ti et/ou Zr et/ou Ta et/ou Th.

9. Dispositif selon l'une quelconque des revendications 1 à 8, **caractérisé en ce qu'**au moins un compartiment (6) voisin du compartiment (5) muni de la cathode à getter (37) présente des conduites d'amenée de gaz (25, 25a) permettant de produire une atmosphère de gaz protecteur.
